# EUROPÄISCHE PATENTSCHRIFT

(11) **EP 1 435 106 B1**
(45) Veröffentlichungstag und Bekanntmachung des Hinweises auf die Patenterteilung: **13.06.2007**
(21) Anmeldenummer: 02767211.2
(22) Anmeldetag: 15.07.2002
(51) Int. Cl.: H01L 21/00

(54) **HEBE- UND STÜTZVORRICHTUNG**
LIFTING AND SUPPORTING DEVICE
DISPOSITIF DE LEVAGE ET DE SOUTIEN

(30) Priorität: 16.07.2001 DE 10134513
(43) Veröffentlichungstag der Anmeldung: 07.07.2004
(73) Patentinhaber: OC Oerlikon Balzers AG, 9496 Balzers (LI)
(72) Erfinder: ELYAAKOUBI, Mustapha, 91130 Ris-Orangis (FR); SCHMITT, Jacques, F-91620 La Ville du Bois (FR)
(74) Vertreter: GROSSE BOCKHORNI SCHUMACHER
(86) Internationale Anmeldenummer: PCT/EP2002/007856
(87) Internationale Veröffentlichungsnummer: WO 2003/008323

(56) Entgegenhaltungen:
- EP-A- 0 821 404
- US-A- 5 669 977
- US-A- 6 132 517
- US-A- 6 146 504
- US-B1- 6 214 122
- PATENT ABSTRACTS OF JAPAN vol. 1998, no. 01, 30. Januar 1998 (1998-01-30) -& JP 09 246362 A (DAINIPPON SCREEN MFG CO LTD), 19. September 1997 (1997-09-19)

## Beschreibung

Die vorliegende Erfindung betrifft eine Plasmaprozess-Anlage zur Behandlung von großflächigen plattenförmigen Elementen mit einer das plattenförmige Element aufnehmenden Hebe- und Stützvorrichtung sowie ein entsprechendes Bearbeitungsverfahren.

Bei der Bearbeitung und insbesondere bei der Beschichtung oder dem Ätzen von Halbleitern, z. B. Silizium-Wafern zur Herstellung von integrierten Schaltkreisen, oder von Dielektrika, wie z. B. Glasplatten zur Herstellung von Flachbildschirnien, ist es erforderlich die Substrate, die hier meist als plattenförmige Elemente vorliegen, zwischen oder während den einzelnen Bearbeitungsstufen zu transportieren, zwischenzulagern usw., also allgemein in bestimmter Weise zu handhaben. Dies ist jedoch im Gegensatz zu anderen Bereichen der Prozesslogistik mit Schwierigkeiten verbunden, da es sich hierbei um äußerst empfindliche Bauteile bzw. Prozesse handelt, bei denen kleinste Störungen zu einer starken Beeinträchtigung oder gar zur Zerstörung der Bauteile führen können.

Ein Problem, das sich allgemein bei der Handhabung von Halbleitern, aber insbesondere bei der Handhabung von Dielektrika ergibt, welche elektrische Schaltungen wie z. B. Dünnfilmtransistoren tragen, ist das Problem der elektrischen Aufladung und der nachfolgenden ungewollten elektrostatischen Entladung. Wie dem schematischen Bild der Figur 6 zu entnehmen ist, kann es durch Verarbeitungsprozesse, z. B. Plasmabeschichtungsverfahren, aber auch durch Reibungsvorgänge beim Transport von plattenförmigen Elementen zu einer elektrostatischen Aufladung der plattenförmigen Elements kommen. Diese Ladung auf dem plattenförmigen Element (4) ist in Figur 6 schematisch dargestellt und mit dem Bezugszeichen 8 bezeichnet. Wird nun das aufgeladene Plattenelement in unterschiedlichem Abstand zum Erdpotenzial gebracht, wie dies z. B. beim Anheben des plattenförmigen Elements geschehen kann, so treten Potenzial Differenzen auf dem plattenförmigen Element (4) auf, die in der Figur 6 mit V₁ und V₂ dargestellt sind. Diese Potenzialdifferenzen auf der Oberfläche des plattenförmigen Elements können nun dazu führen, dass es zu einer ungewollten elektrostatischen Entladung über die auf der Oberfläche aufgebrachten Schaltkreise oder Dünnfilmtransistoren kommt. Dies ist schematisch in Figur 6 in dem Rahmen in der Bildmitte gezeigt. Die elektrostatische Entladung kann aber zu einer Zerstörung des Bauteils führen, so dass im Zweifelsfall das gesamte plattenförmige Element mit seiner Vielzahl von Schaltkreisen oder Dünnfilmtransistoren zum Ausschuss wird.

Diesem Problem ist man bisher dadurch begegnet, dass man zum einen versucht hat, eine Aufladung der plattenförmigen Elemente z. B. durch Ionisierung der Umgebungsluft zu vermeiden. Es hat sich aber herausgestellt, dass eine vollständige Vermeidung einer elektrostatischen Aufladung praktisch kaum durchführbar ist. Ein weiterer Ansatz zur Lösung des Problems der ungewollten elektrostatischen Entladung ist der, dass sämtliche Schaltungen auf dem Halbleiter oder dem Dielektrikum durch zusätzlich angebrachte Leitungen, sogenannten bus bars, während des Herstellungsprozesses kurzgeschlossen werden. Dies hat jedoch den Nachteil, dass zum einen ein erhöhter Aufwand zur Aufbringung und abschließenden Entfernung der bus bars erforderlich ist. Außerdem behindern die bus barse den weiteren Herstellungsprozess.

Ein weiteres Problem bei der Handhabung von plattenförmigen Elementen besteht insbesondere bei Plasmaverfahren darin, dass durch die Hebe- und Stützvorrichtungen in den Plasmakammern das Plasma gestört wird, was zu Auswirkungen bei den Eigenschaften der mit dem Plasma zu behandelnden Elemente führt. So werden in Plasmaanlagen üblicherweise die zu behandelnden Elemente, wie plattenförmige Elemente, wie z. B. Silizumwafer oder Glasplatten, auf metallischen Grundplatten abgelegt, um mit dem Plasmaverfahren behandelt zu werden. An den Rändern der Grundplatte sind hierbei Stifte vorgesehen, die in der Grundplatte versenkbar sind, um die zu behandelnden plattenförmigen Elemente anzuheben und abzusenken, damit eine Greifeinrichtung z. B. ein Roboterarm mit einer gabelförmigen Halterung, die plattenförmigen Elemente untergreifen und von einer Bearbeitungsstation zur nächsten transportieren kann. Die Stifte der bekannten Hebe- und Stützvorrichtung sind am Rand der Grundplatte angeordnet, da die Stiftlöcher, in denen die Stifte geführt werden, Inhomogenitäten in der metallischen Grundplatte darstellen und so zu einer Veränderung des Plasmas über diesen Bereichen führen können. Die Veränderung des Plasmas über diesen Bereichen hat jedoch zur Folge, dass hier beispielsweise die Abscheidung von Schichten oder die Ätzung mittels Plasma gerstört werden würde. Da aber üblicherweise an den Rändern der plattenförmigen Elemente keine Schaltkreise oder Dünnfilmtransistoren, d. h. aktive Elemente, aufgebracht werden, ist die Anordnung der Stifte mit den Stiftlöchern in diesen Bereichen unschädlich. Mit der zunehmenden Größe und der abnehmenden Dicke der plattenförmigen Elemente führt dies jedoch zu dem Problem, dass auch Stifte in der Mitte der Grundplatte vorgesehen werden müssen, um eine ausreichende Abstützung des plattenförmigen Elements beim Anheben bzw. Absenken zu gewährleisten. Auf diese Weise existieren jedoch durch die Stiftlöcher beim Plasmaverfahren auch Inhomogenitäten im Bereich der Mitte der Hebe- und Stützvorrichtung, wo es wünschenswert wäre, ebenfalls aktive Bereiche der plattenförmigen Elemente herstellen zu können. Bisher behilft man sich hierbei mit der Tatsache, dass auf einem plattenförmigen Element mehrere Endbauteile erzeugt werden, die am Schluss durch Trennen des plattenförmigen Elements voneinander getrennt werden. Somit ist es also möglich an den Trennstellen entsprechende Stifte vorzusehen, da auch hier in diesen Bereiche ein Störung des Plasmas durch die darunter liegenden Stifte bzw. Stiftlöcher keine Auswirkung hat. Da jedoch beispielsweise für die Herstellung von Flachbildschirmen gilt, dass die einzelnen aktiven Bereichen der plattenförmigen Elemente bei abnehmender Dicke der plattenförmigen Elemente immer größer werden, sind dieser Abhilfe gewisse Grenzen gesetzt.

Weiterhin ist es beispielsweise aus der US 6 228 438 B1 bekannt, im Plasma zu behandelnde Elemente auf Stiften zu lagern, um unterhalb des zu behandelnden Elements eine dielektrische Schicht auszubilden. Hierbei treten durch die Stifte ebenfalls Störungen im Plasma im Bereich der Stifte auf. Diese werden durch zusätzliche Aussparungen um die Stifte in der Grundplatte abgemildert.

Das Dokument US-A-5 669 977 zeigt eine Plasmaprozessanlage zur Behandlung von plattenförmigen Elementen, mit einer das plattenförmige Element aufnehmenden Hebe-und Stützvorrichtung mit einem Grundelement auf dem eine Vielzahl von Stiften angeordnet ist, die in in dem Grundelement vorgesehenen Stiftlöchern versenkbar sind, und auf deren Enden das plattenförmige Element zur Handhabung oder während der Plasmabehandlung gelagert ist, wobei der Durchmesser der Stifte 0.76 mm und der der Stiftlöcher 1.0 mm beträgt.

Das Dokument EP-A-0 821 404 zeigt eine Prozessanlage zur Wärme-Behandlung von großflächigen, plattenförmigen Elementen, mit einer das plattenförmige Element aufnehmenden Hebe-und Stützvorrichtung mit einem metallischen Grundelement auf dem eine Vielzahl von Stiften angeordnet ist, die in in dem Grundelement vorgesehenen Stiftlöchern versenkbar sind, und auf deren Enden das plattenförmige Element zur Handhabung oder während der Behandlung gelagert ist, wobei die Stifte aus Quarz gebildet sind, der Durchmesser der Stifte 2 mm und der der Stiftlöcher 4.75 mm beträgt.

Dementsprechend ist es Aufgabe der vorliegenden Erfindung ganz allgemein eine Hebe-und Stützvorrichtung zur Handhabung und Lagerung von plattenförmigen, insbesondere großflächigen, Elementen zu schaffen, die bei einer Vielzahl von Prozessen einsatzfähig ist, und die die oben aufgezeigten Probleme vermeidet. Insbesondere ist es die Aufgabe der vorliegenden Erfindung eine Hebe- und Stützvorrichtung für entsprechende Elemente zu schaffen, die ohne zusätzliche und aufwendige Maßnahmen Schäden durch unerwünschte elektrostatische Entladungen vermeidet. Außerdem soll die Hebe- und Stützvorrichtung eine möglichst geringe Störung eines zur Behandlung der plattenförmigen Elementes vorgesehenen Plasmas ausüben, so dass negative Auswirkungen auf die Herstellung und die Eigenschaften der plattenförmigen Elemente vermieden werden.

Diese Aufgabe wird gelöst durch eine Plasmaprozessanlage nach Anspruch 1 bzw. ein Verfahren zum Bearbeiten von plattenförmigen Substraten nach Anspruch Vorteilhafte Ausgestaltungen sind Gegenstand der Unteransprüche.

Wesentlich für die Lösung der oben genannten Aufgabe und aller ihrer Teilaspekte ist, dass bei einer Hebe- und Stützvorrichtung mit einem Grundelement, auf der eine Vielzahl von Stiften zum Tragen von plattenförmigen Elementen vorgesehen ist, der Durchmesser der Stifte bzw. der Stiftlöcher, in denen die Stifte versenkbar sein können, derart klein gewählt ist, dass die oben geschilderten Probleme nicht auftreten können bzw. im wesentlichen vermieden werden. Wie nachfolgend näher erläutert werden wird, ist es gerade die dünne bzw. schlanke Ausbildung der Stifte, die verschiedene Probleme bei den gattungsgemäßen Hebe-und Stützvorrichtungen löst.

So wird, wie die Erfinder nachgewiesen haben, das Problem der ungewollten elektrostatischen Entladung dadurch vermieden, dass bei einer dünnen Ausbildung von dielektrischen Stiften die Erzeugung von Potenzialunterschieden auf der Oberfläche der plattenförmigen Elemente deutlich reduziert wird. Abhängig von den Eigenschaften des plattenförmigen Elements, z. B. der Dicke und der Art des plattenförmigen Elements, z. B. Halbleiter oder Dielektrikum, sowie der Anzahl und Art der elektrischen Bauteile, wie z. B. Transistoren, führt die Verringerung der Dicke der Stifte zu einer Vermeidung von elektrostatischen Entladungen und somit einer Beschädigung des zu handhabenden plattenförmigen Elements. Erfindungsgemäß Weise sind die Stifte aus einem dielektrischen Werkstoff gefertigt, da bei einem aus Metall gefertigten Grundelement, für Plasmaprozessanlagen, leitfähige Stifte zur Ausbildung von hohen Potenzialunterschieden auf dem plattenförmigen Element führen würden, welche auch durch eine dünne Ausbildung der Stifte nicht vermieden werden könnte.

Um die auf den Stiften zu lagernden plattenförmigen Elementen gegenüber dem Grundelement verschieben zu können, sind die Stifte in dem Grundelement versenkbar, wozu in diesem Stiftlöcher vorgesehen sind. Das Grundelement kann eine Platte, ein Gitter, Transportgabeln oder dgl. sein.

In Plasmaprozessanlagen wird das plattenförmige Element üblicherweise während des Plasmaprozesses auf dem Grundelement abgelegt, das zur Erzeugung des Plasmas metallisch ausgeführt ist. Die Stifte der Hebe- und Stützvorrichtung sind versenkbar in dem Grundelement angeordnet, da sie nur zum Anheben oder Absenken des plattenförmigen Elements dienen. Die hierfür vorgesehenen Stiftlöcher erzeugen jedoch die erfindungsgemäß zu vermeidenden Inhomogenitäten in dem Grundelement, die das Plasma in den Bereichen darüber stören. Entsprechend ist der Durchmesser der Stiftlöcher und damit wiederum der Durchmesser der darin geführten Stifte derart klein zu wählen, dass eine Störung des Plasmas und damit eine Beschädigung des plattenförmigen Elements im wesentlichen verhindert wird. Da eine eventuelle Störung des Plasmas durch die Inhomogenität des Grundelements auch von dem Plasma selbst und dem zu behandelnden Element abhängt, ist der Durchmesser der Stiftlöcher bzw. der Stifte entsprechend des Anwendungsfalls zu wählen.

Allgemein ist jedoch hervorzuheben, dass zur Vermeidung des Problems der ungewollten elektrostatischen Entladung als auch zur Vermeidung von Plasmastörungen der Durchmesser der Stifte in der Hebe- und Stützvorrichtung möglichst klein zu wählen ist. Die genaue Grenze des Durchmessers der Stifte bzw. der Stiftlöcher ist anhand des Einzelfalls zu ermitteln, was jedoch für den Fachmann kein Problem darstellt. Aufgrund der Kenntnisse eines Fachmanns und der vorliegenden Offenbarung kann dieser die Grenzwerte im Einzelfall entweder durch geeignete Versuche oder durch numerische Simulation ermitteln.

Allgemein hat sich jedoch gezeigt, dass insbesondere für den Fall, dass die Hebe- und Stützvorrichtung in Plasmaprozessanlagen verwendet wird, der Durchmesser der Stifte kleiner als die Dicke der Plasmahülle sein soll, die das Plasma umgibt.

Insbesondere für die Vermeidung ungewollter elektrostatischer Entladungen hat es sich bewährt, dass der Durchmesser der Stifte kleiner als der 15. Teil seiner über dem Grundelement, insbesondere metallischen Grundelement, hervorstehbaren Länge ist. Als Größe für den Durchmesser der Stifte hat sich ergeben, dass der Durchmesser der Stifte kleiner 3 mm, vorzugsweise kleiner 2 mm und insbesondere gleich 1,8 mm sein sollte.

Um eine ausreichende Abstützung der zu tragenden plattenförmigen Elemente zu gewährleisten und eine Überbeanspruchung der dünnen Stifte zu vermeiden, ist es vorteilhaft eine ausreichende Anzahl der Stifte pro m² Grundelementfläche vorzusehen. Vorzugsweise sollte die Anzahl der Stifte pro m² Grundelementfläche über 5, besonders vorzugsweise über 10 und insbesondere über 15 liegen. Insbesondere bei sehr dünnen plattenförmigen Elementen, wie dies z. B. bei Glassubstraten für Flachbildschirme der Fall ist, sollte der mittlere Abstand der Stifte nicht größer als 300 mm sein, wobei es in allen Fällen vorteilhaft ist, dass die Stifte gleichmäßig über dem Grundelement verteilt sind.

Es ist bevorzugt, die Stifte aus einem Dielektrikum mit niedriger Dielektrizitätskonstante zu fertigen, um hierdurch die Gefahr von Potenzialunterschieden auf der Oberfläche der plattenförmigen Elemente weiter zu reduzieren.

Allerdings ist zu beachten, dass die Stifte auch geeignete mechanische Eigenschaften aufweisen. Hierzu ist es besonders vorteilhaft, wenn die Stifte eine ausreichende Elastizität aufweisen, also aus einem geeigneten elastischen Material gebildet sind. Dies verhindert nämlich, dass die sehr dünnen Stifte bei Aufbringung von Querkräften abbrechen. Querkräfte können beispielsweise durch thermische Ausdehnung des aufgenommenen plattenförmigen Elements während der Behandlung oder durch nicht richtig ausgerichtete Stifte beim Anheben oder Absenken auftreten. Je nach Einsatzgebiet hat es sich bewährt, die Stifte aus einem Polymer oder aus einer Keramik zu fertigen. Besonders vorteilhafte Materialen sind hier Polytetrafluorethylen, Polyisobutylen, Polyacrylrate, Polyethylen sowie Quarz, Cordierit, Aluminiumoxid oder Zirkon.

Um die Querkräfte auf die Stifte zu verringern ist es auch vorteilhaft die Haftung zwischen dem Ende der Stifte, auf denen das plattenförmige Element gelagert ist und dem plattenförmigen Element zu vermeiden. Insbesondere sollte eine Verklebung vermieden werden. Dies kann beispielsweise dadurch erreicht werden, dass die Stifte um ihre Längsachse drehbar angeordnet sind. Durch die Drehung der Stifte wird eine zu starke Haftung der Enden der Stifte mit dem plattenförmigen Element vermieden, so dass die zur Übertragung von Querkräften notwendige Reibungskraft nicht erreicht werden kann. Alternative zu einer Drehung der Stifte um ihre Längsachse können die Stifte auch eine entlang ihrer Längsachse ausgeführte oszillierende translatorische Bewegung ausführen. Zu diesem Zweck kann es vorteilhaft sein, einen Piezo-Wandler vorzusehen, der die translatorischen Bewegungen erzeugen kann.

Eine weitere Möglichkeit, zu hohe Querkräfte zu vermeiden, besteht darin, zwei voneinander unabhängige Sätze von Stiften vorzusehen, die abwechselnd das plattenförmige Element aufnehmen oder aufheben und absenken.

Zum Zweck der Vermeidung von zu hohen Querkräften ist es auch vorteilhaft, die Enden der Stifte auf denen das plattenförmige Element lagert so auszubilden, dass keine hohen Reibungskräfte erzeugt werden können. Hierzu bietet es sich an, die Oberfläche glatt zu polieren oder eine Beschichtung mit niedrigem Reibungskoeffizienten aufzubringen.

Weitere Vorteile, Kennzeichen und Merkmale der vorliegenden Erfindung werden bei der nachfolgenden detaillierten Beschreibung eines Ausführungsbeispiels anhand der beigefügten Zeichnungen deutlich. Die Zeichnungen zeigen dabei sämtlich in rein schematischer Weise in
- Fig. 1: eine Hebe- und Stützvorrichtung in Querschnittsansicht mit einer darauf angeordneten Glasplatte zum einen während der Plasmabehandlung und zum anderen beim Anheben der Glasplatte;
- Fig. 2: einen Querschnitt der Hebe- und Stützvorrichtung mit einer angehobenen Glasplatte;
- Fig.3: einen Querschnitt einer Hebe- und Stützvorrichtung mit einer angehobenen Glasplatte, bei welcher die Stifte drehbar angeordnet sind;
- Fig. 4: einen Querschnitt durch eine Hebe- und Stützvorrichtung mit angehobener Glasplatte, bei der die Stifte über einen Piezo-Wandler entlang ihrer Längsrichtung schwingen können;
- Fig. 5: mehrere Querschnitte durch eine Hebe- und Stützvorrichtung beim Absenken einer Glasplatte wobei die Hebe- und Stützvorrichtung zwei Sätze von Stiften aufweist, um die Glasplatte abwechselnd zu tragen, sowie ein Diagramm, das den Weg-Zeit-Verlauf der beiden Sätze an Stiften sowie der Glasplatte zeigt; und in
- Fig.6: eine schematische Darstellung der unerwünschten inhomogenen Spannungsverteilung einer mit einer elektrostatischen Ladung beaufschlagten Glasplatte bei unterschiedlichem Abstand zum Grund, wobei der Spannungsunterschied zu einer ungewünschten elektrostatischen Entladung auf der mit Schaltkreisen versehenen Glasplatte führen kann.

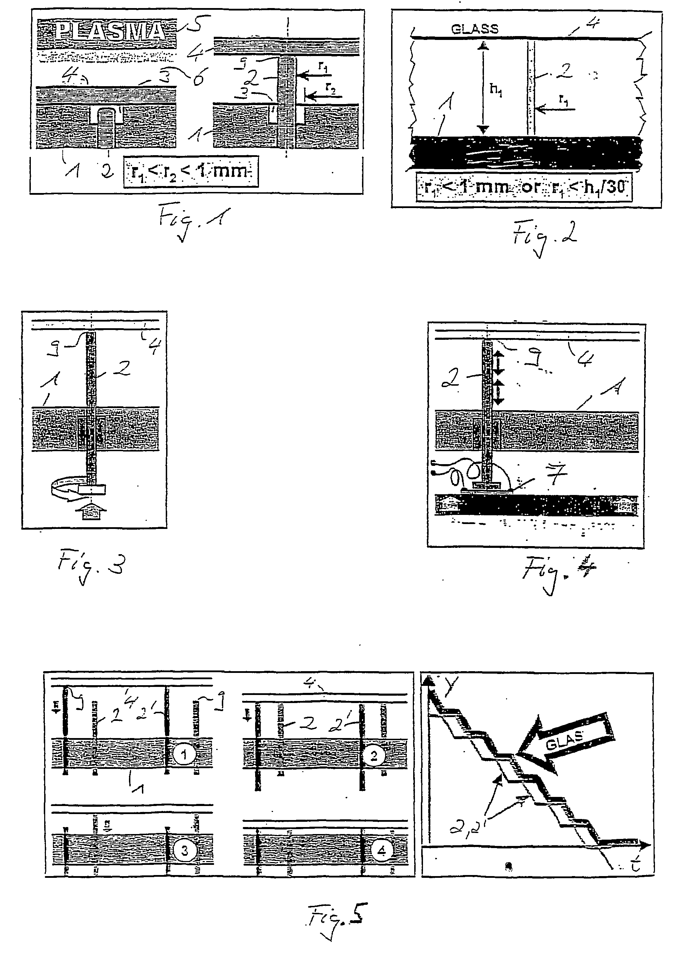

Fig. 1 zeigt in einem Querschnitt in zwei Teilbilden einen Ausschnitt einer Ausführungsform der Hebe- und Stützvorrichtung, bei der einmal der gezeigte Stift 2 in der Grundplatte 1 versenkt ist und das zu behandelnde plattenförmige Element 4, z. B: eine Glasplatte, auf der Grundplatte 1 abgelegt ist, sowie andererseits den ausgefahrenen Stift 2, der von der Grundplatte 1 hervorsteht und an dessen einem Ende 9 die Glasplatte 4 aufliegt. Bei der schematischen Darstellung der Figur 1 ist das Stiftloch 3 nur in einem oberen Bereich dargestellt. Allerdings kann das Stiftloch 3 auch so ausgeführt sein, das es über seine gesamte Höhe den gleichen Durchmesser besitzt. Zur besseren Darstellung ist hier jedoch ein Stiftloch gezeigt, dass in seinem oberen Bereich einen deutlich größeren Durchmesser aufweist, als der Stift 2. Obwohl dies eine mögliche Ausführungsform ist, wird üblicherweise die bevorzugte Ausführungsform die sein, bei der das Stiftloch 3 lediglich minimal im Durchmesser größer ist als der Stift 2, und zwar nur insoweit, dass eine freie Bewegung des Stifts 2 im Stiftloch 3 ermöglicht wird. In diesem Fall ist auch eine Änderung des Durchmessers des Stiftlochs 3 über der Länge nicht erforderlich.

Wie in Figur 1 ebenfalls gezeigt ist, wird die Hebe- und Stützvorrichtung bei der Plasmabehandlung einer Glasplatte 4 verwendet. Hierbei wird oberhalb der Glasplatte 4 ein Plasma 5 gezündet, wenn die Glasplatte 4 auf die metallische Grundplatte 1 abgelegt ist. Zwischen Plasma 5 und Glasplatte 4 bildet sich ein plasmafreier Zwischenraum aus, der hier als Plasmahülle 6 bezeichnet wird. Die Plasmahülle 6 weist üblicherweise eine Dicke von 2 bis 3 mm auf. Entsprechend ist die bevorzugte Ausführungsform gemäß Figur 1 so ausgebildet, dass sowohl der Durchmesser der Stiftlöcher 3 als auch entsprechend jener der Stifte 2 ldeiner ist als die Dicke der Plasmahülle 6. Folglich ist der Radius der Stiftlöcher 3 sowie entsprechend der der Stifte 2 im gezeigten Ausführungsbeispiel kleiner 1 mm.

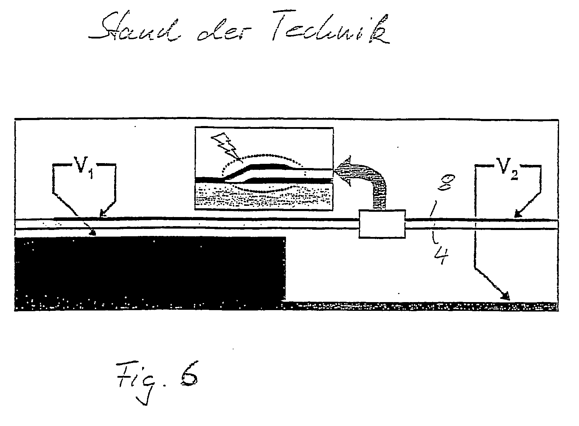

Figur 2 zeigt ebenfalls einen Ausschnitt einer Ausführungsform der Hebe- und Stützvorrichtung im Querschnitt, wobei hier der Stift 2 vollständig aus der Grundplatte 1 ausgefahren ist (das Stiftloch 3 ist hier nicht gezeigt). Bei dieser Ausführungsform ist eine weitere Möglichkeit der erfindungsgemäßen Gestaltung der Stifte 2 schematisch dargestellt, nämlich die, dass der Radius der Stifte 2 kleiner als der dem 30. Teil seiner gesamten Ausfahrhöhe h₁ ist. Diese Ausführungsform ist insbesondere auf die Anwendung bei der Handhabung von Glasplatten ausgerichtet, die mit Schaltkreisen versehen sind und durch elektrostatische Aufladung einer Beschädigung durch unerwünschte elektrostatische Entladung ausgesetzt sind.

Die Figuren 3 bis 5 zeigen jeweils Ausschnitte von Hebe- und Stützvorrichtungen im Querschnitt, bei denen Maßnahmen vorgesehen sind, um eine zu hohe Belastung der Stifte 2 durch unerwünschte Querkräfte beim Anheben bzw. Absenken oder der Behandlung der plattenförmigen Elemente 4 zu vermeiden. Insbesondere sind die in diesen Figuren 3 bis 5 gezeigten Beispiele darauf ausgerichtet, eine zu starke Haftung zwischen den Enden 9 der Stifte 2 einerseits und den plattenförmigen Elementen 4 andererseits zu vermeiden, also die Reibungskräfte zu minimieren.

Bei der Ausführungsform gemäß der Figur 3 sind die Stifte 2 drehbar gelagert, so dass sie sich um ihre Längsachse drehen können. Beim Anheben bzw. Absenken oder bei der Behandlung der plattenförmigen Elemente 4 werden die Stifte 2 gedreht, so dass ein Festldeben oder Anhaften der Enden 9 der Stifte 2 an dem plattenförmigen Element 4 vermieden wird. Dadurch wiederum wird erreicht, dass keine zu starken Querkräfte auf die Stifte 2 ausgeübt werden können, die beispielsweise aus einer nicht exakten Ausrichtung der Stifte 2 resultieren könnten.

Bei der Ausführungsform gemäß Figur 4 wird dieses Problem der Anhaftung bzw. der Querkräfte dadurch gelöst, dass die Stifte 2 beispielsweise durch Piezo-Wandler in translatorische Schwingungen entlang der Längsachse der Stifte 2 versetzt werden, so dass die Stifte 2 periodisch von der Last des plattenförmigen Elements 4 entlastet werden. Auch hier wird dadurch vermieden, dass sich eine zu starke Bindung zwischen dem Ende 9 der Stifte 2 und dem plattenförmigen Element 4 ausbildet, was zur Übertragung von unzulässig hohen Querkräften auf die Stifte 2 führen könnte.

Eine weitere Lösung für dieses Problem ist in der Ausführungsform gemäß Figur 5 gezeigt. Hier sind 2 Sätze von Stiften 2 bzw. 2' in der erfindungsgemäßen Hebe- und Stützvorrichtung vorgesehen, die abwechselnd die Tragefunktion für das plattenförmige Element 4 beim Anheben bzw. Absenken oder dgl. übernehmen. Dies kann beispielsweise dadurch erreicht werden, dass die Stifte 2 nach einem stufenförmigen Verlauf im Weg-Zeit-Diagramm bewegt werden, so dass das plattenförmige Element 4 abwechselnd einmal auf dem einen Satz von Stiften 2 und dem anderen Satz von Stiften 2' gelagert ist.

## Patentansprüche

1. Plasmaprozessanlage zur Behandlung von grossflächigen plattenförmigen Elementen, mit einer das plattenförmige Element (4) aufnehmenden Hebe-und Stützvorrichtung mit einem metallischen Grundelement (1), auf dem eine Vielzahl von Stiften (2) angeordnet ist, die in in dem Grundelement vorgesehenen Stiftlöchern (3) versenkbar sind, und auf deren Enden (9) das plattenförmige Element (4) zur Handhabung oder während der Plasmabehandlung gelagert ist, wobei das plattenförmige Element (4) eine elektrostatische Ladung aufweisen kann, wobei
der Durchmesser der Stiftlöcher (3) und der Stifte (2) derart klein gewählt ist, dass angepasst an das durch das Plasma zu behandelnde plattenförmige Element (4) bei der Plasmabearbeitung eine Störung des Plasmas im Bereich der Stiftlöcher (3) oder Stifte. (2) und eine ungewollte elektrostatische Entladung auf dem plattenförmigen Element (4) bei Handhabung und Lagerung im wesentlichen vermieden werden, wobei die Stifte (2) aus dielektrischem Material gebildet sind und der Durchmesser der Stifte kleiner 3 mm ist.

2. Plasmaprozeßanlage nach einem der Ansprüche 1,
**dadurch gekennzeichnet, dass**
der Durchmesser der Stifte (2) kleiner als die Dicke der Plasmahülle ist.

3. Plasmaprozeßanlage nach einem der vorhergehenden Ansprüche,
**dadurch gekennzeichnet, dass**
der Durchmesser der Stifte (2) kleiner als der fünfzehnte Teil seiner über der Grundplatte (1) hervorstehbaren Länge (h₁) ist.

4. Plasmaprozeßanlage nach einem der vorhergehenden Ansprüche,
**dadurch gekennzeichnet, dass**
der Durchmesser der Stifte (2) kleiner 2 mm, insbesondere gleich 1,8 mm ist.

5. Plasmaprozeßanlage nach einem der vorhergehenden Ansprüche,
**dadurch gekennzeichnet, dass**
die Anzahl der Stifte (2) pro m² Grundplattenfläche größer 5 ist.

6. Plasmaprozeßanlage nach einem der vorhergehende Ansprüche,
**dadurch gekennzeichnet, dass**
die Anzahl der Stifte (2) pro m² Grundplattenfläche größer 10 ist.

7. Plasmaprozeßanlage nach einem der vorhergehenden Ansprüche,
**dadurch gekennzeichnet, dass**
die Anzahl der Stifte (2) pro m² Grundplattenfläche größer 15 ist.

8. Plasmaprozeßanlage nach einem der vorhergehenden Ansprüche,
**dadurch gekennzeichnet, dass**
der mittlere Abstand der Stifte (2) nicht größer als 300 mm ist und dass die Stifte (2) gleichmäßig über der Grundplatte (1) verteilt sind.

9. Plasmaprozeßanlage nach einem der vorhergehenden Ansprüche,
**dadurch gekennzeichnet, dass**
die Stifte (2) aus einem Dielektrikum mit niedriger Dielektrizitätskonstante gebildet sind.

10. Plasmaprozeßanlage nach einem der vorhergehenden Ansprüche,
**dadurch gekennzeichnet, dass**
die Stifte (2) aus einem elastischen Material gebildet sind.

11. Plasmaprozeßanlage nach einem der vorhergehenden Ansprüche,
**dadurch gekennzeichnet, dass**
die Stifte (2) aus einem Polymer gebildet sind.

12. Plasmaprozeßanlage nach einem der vorhergehenden Ansprüche,
**dadurch gekennzeichnet, dass**
die Stifte (2) aus Polytetrafluorethylen, Polyisobutylen, Polyacrylaten oder Polyethylen, oder aus Keramik gebildet sind.

13. Plasmaprozeßanlage nach einem der Ansprüche 1 bis 9,
**dadurch gekennzeichnet, dass**
die Stifte (2) aus Quartz, Cordierit, Aluminiumoxid oder Zirkon gebildet sind.

14. Plasmaprozeßanlage nach einem der vorhergehenden Ansprüche,
**dadurch gekennzeichnet, dass**
die Stifte um ihre Längsachse drehbar angeordnet sind.

15. Plasmaprozeßanlage nach einem der vorhergehenden Ansprüche,
**dadurch gekennzeichnet, dass**
die Stifte entlang ihrer Längsachse eine ozillierende Schiebebewegung ausführen können.

16. Plasmaprozeßanlage nach einem der vorhergehenden Ansprüche,
**dadurch gekennzeichnet, dass**
zwei voneinander unabhängige Sätze von Stiften vorgesehen sind, die unabhängige Hebe- und Senkbewegungen erlauben.

17. Plasmaprozeßanlage nach einem der vorhergehenden Ansprüche,
**dadurch gekennzeichnet, dass**
die Stifte an ihren Enden, auf denen das plattenförmige Element lagert, eine glatt polierte Oberfläche und/oder eine Beschichtung mit niedrigem Reibungskoeffizienten aufweisen.

18. Verfahren zum Bearbeiten von plattenförmigen Substraten, in eine Plasmaprozeßanlage,
**dadurch gekennzeichnet, dass**
die plattenförmigen Substrate auf Hebe- und Stützvorrichtungen in eine Plasmaprozeßanlage nach einem der vorhergehenden Ansprüche bewegt werden.

## Claims

1. Plasma processing plant for treating large-area plate-like elements, with a lifting and supporting device receiving the plate-like element (4), with a metallic base element (1) over which a plurality of pins (2) are arranged which can be lowered into pin holes (3) provided in the base element and on whose ends (9) the plate-like element (4) is carried for manipulation or during plasma treatment, at which time the plate-like element may have an electrostatic charge, the diameter of the pin holes (3) and that of the pins (2) being made so small that, when adapted to the plate-like element (4) to be treated by the plasma, disturbance of the plasma in the region of the pin holes (3) or pins (2) during plasma processing, and undesired electrostatic discharge on the plate-like element (4) during manipulation and storage, are substantially prevented, the pins (2) being made of non-conducting material, and the diameter of the pins being less than 3 mm.

2. Plasma processing plant according to Claim 1,
**characterized in that**
the diameter of the pins (2) is less than the thickness of the plasma envelope.

3. Plasma processing plant according to either of the preceding claims,
**characterized in that**
the diameter of the pins (2) is less than one fifteenth of the length of pin (h1) that can be extended above the base plate (1).

4. Plasma processing plant according to any one of the preceding claims,
**characterized in that**
the diameter of the pins (2) is less than 2 mm, and in particular equal to 1.8 mm.

5. Plasma processing plant according to any one of the preceding claims,
**characterized in that**
the number of pins (2) per m² of base plate surface area is greater than 5.

6. Plasma processing plant according to any one of the preceding claims,
**characterized in that**
the number of pins (2) per m² of base plate surface area is greater than 10.

7. Plasma processing plant according to any one of the preceding claims,
**characterized in that**
the number of pins (2) per m² of base plate surface area is greater than 15.

8. Plasma processing plant according to any one of the preceding claims,
**characterized in that**
the average interval between pins (2) is not greater than 300 mm, and the pins (2) are uniformly distributed over the base plate (1).

9. Plasma processing plant according to any one of the preceding claims,
**characterized in that**
the pins (2) are made of non-conducting material with a low dielectric constant.

10. Plasma processing plant according to any one of the preceding claims,
**characterized in that**
the pins (2) are made of elastic material.

11. Plasma processing plant according to any one of the preceding claims,
**characterized in that**
the pins are made of a polymer.

12. Plasma processing plant according to any one of the preceding claims,
**characterized in that**
the pins (2) are made of polytetrafluoroethylene, polyisobutene, polyacrylates or polyethylene, or ceramic.

13. Plasma processing plant according to any one of Claims 1 to 9,
**characterized in that**
the pins (2) are made of quartz, cordierite, aluminium oxide or zircon.

14. Plasma processing plant according to any one of the preceding claims,
**characterized in that**
the pins are arranged rotatably about their longitudinal axis.

15. Plasma processing plant according to any one of the preceding claims,
**characterized in that**
the pins are capable of executing an oscillating translational motion along their longitudinal axis.

16. Plasma processing plant according to any one of the preceding claims,
**characterized in that**
two independent sets of pins are provided, permitting independent raising and lowering movements.

17. Plasma processing plant according to any one of the preceding claims,
**characterized in that**
the tips of the pins on which the plate-like element is carried have a smoothly polished surface and/or a coating with a low coefficient of friction.

18. Method for processing plate-like substrates in a plasma processing plant,
**characterized in that**
the plate-like substrates are moved on lifting and supporting devices in a plasma processing plant according to any one of the preceding claims.

## Revendications

1. Installation de traitement par plasma pour le traitement d'éléments en forme de plaque à grande superficie, comprenant un dispositif de levage et de support devant recevoir l'élément en forme de plaque (4), lequel dispositif comprend un élément de base métallique (1) sur lequel est disposée une pluralité de tiges (2) qui peuvent être enfoncées dans des trous de tige (3) prévus dans l'élément de base, et sur les extrémités (9) desquelles l'élément en forme de plaque (4) est placé pour la manipulation ou pendant le traitement par plasma, dans lequel l'élément en forme de plaque (4) peut présenter une charge électrostatique, dans lequel
le diamètre des trous de tige (3) et des tiges (2) est si petit que, en étant adapté à l'élément en forme de plaque (4) à traiter par plasma, il permet d'éviter dans une large mesure, lors du traitement par plasma, une perturbation du plasma dans la zone des trous de tige (3) ou des tiges (2) et une décharge électrostatique non souhaitée sur l'élément en forme de plaque (4) lors de la manipulation et du stockage, dans lequel les tiges (2) sont faites d'un matériau diélectrique et le diamètre des tiges est inférieur à 3 mm.

2. Installation de traitement par plasma selon la revendication 1,
**caractérisée en ce que**
le diamètre des tiges (2) est inférieur à l'épaisseur de la gaine de plasma.

3. Installation de traitement par plasma selon l'une quelconque des revendications précédentes,
**caractérisée en ce que**
le diamètre des tiges (2) est inférieur au quinzième de leur longueur (h₁) dépassant de la plaque de base (1).

4. Installation de traitement par plasma selon l'une quelconque des revendications précédentes,
**caractérisée en ce que**
le diamètre des tiges (2) est inférieur à 2 mm, en particulier égal à 1,8 mm.

5. Installation de traitement par plasma selon l'une quelconque des revendications précédentes,
**caractérisée en ce que**
le nombre des tiges (2) par m² de superficie de la plaque de base est supérieur à 5.

6. Installation de traitement par plasma selon l'une quelconque des revendications précédentes,
**caractérisée en ce que**
le nombre des tiges (2) par m² de superficie de la plaque de base est supérieur à 10.

7. Installation de traitement par plasma selon l'une quelconque des revendications précédentes,
**caractérisée en ce que**
le nombre des tiges (2) par m² de superficie de la plaque de base est supérieur à 15.

8. Installation de traitement par plasma selon l'une quelconque des revendications précédentes,
**caractérisée en ce que**
la distance moyenne entre les tiges (2) ne dépasse pas 300 mm et **en ce que** les tiges (2) sont réparties de manière régulière sur la plaque de base (1).

9. Installation de traitement par plasma selon l'une quelconque des revendications précédentes,
**caractérisée en ce que**
les tiges (2) sont faites d'un matériau diélectrique ayant une faible constante diélectrique.

10. Installation de traitement par plasma selon l'une quelconque des revendications précédentes,
**caractérisée en ce que**
les tiges (2) sont faites d'un matériau élastique.

11. Installation de traitement par plasma selon l'une quelconque des revendications précédentes,
**caractérisée en ce que** les tiges (2) sont faites d'un polymère.

12. Installation de traitement par plasma selon l'une quelconque des revendications précédentes,
**caractérisée en ce que**
les tiges (2) sont faites de polytétrafluoroéthylène, de polyisobutylène, de polyacrylates ou de polyéthylène, ou bien de céramique.

13. Installation de traitement par plasma selon l'une quelconque des revendications 1 à 9,
**caractérisée en ce que**
les tiges (2) sont faites de quartz, de cordiérite, d'oxyde d'aluminium ou de zirconium.

14. Installation de traitement par plasma selon l'une quelconque des revendications précédentes,
**caractérisée en ce que**
les tiges sont disposées de manière à pouvoir tourner autour de leur axe longitudinal.

15. Installation de traitement par plasma selon l'une quelconque des revendications précédentes,
**caractérisée en ce que**
les tiges peuvent exécuter un mouvement de coulissement oscillatoire le long de leur axe longitudinal.

16. Installation de traitement par plasma selon l'une quelconque des revendications précédentes,
**caractérisée en ce que**
deux groupes de tiges indépendants l'un de l'autre, qui permettent d'exécuter des mouvements indépendants de levage et d'abaissement, sont prévus.

17. Installation de traitement par plasma selon l'une quelconque des revendications précédentes,
**caractérisée en ce que**
les tiges présentent, au niveau de leurs extrémités sur lesquelles se trouve l'élément en forme de plaque, une surface polie lisse et/ou un revêtement à faible coefficient de frottement.

18. Procédé de traitement de substrats en forme de plaque dans une installation de traitement par plasma,
**caractérisé en ce que**
les substrats en forme de plaque sont déplacés sur des dispositifs de levage et d'abaissement dans une installation de traitement par plasma selon l'une quelconque des revendications précédentes.
